# EUROPEAN PATENT APPLICATION

(11) **EP 2 341 528 A1**
(43) Date of publication of application: **06.07.2011**
(21) Application number: 10150107.0
(22) Date of filing: 05.01.2010
(51) Int. Cl.: H01L 21/329, H01L 29/06, H01L 29/32, H01L 29/861

(54) **Power Semiconductor Device and its manufacturing method**

(71) Applicant: ABB Technology AG, 8050 Zürich (CH)
(72) Inventor: Matthias, Sven, CH-5600, Lenzburg (CH); Kopta Arnost, CH-8049 Zürich (CH); Munaf Rahimo, CH-5619 Uezwil (CH)
(74) Representative: ABB Patent Attorneys

(57) **Abstract**

A semiconductor device (1) and a method for producing such semiconductor device are proposed. The semiconductor device comprises a first layer (2) including a base layer (4) and a cathode layer (12) of a first conductivity type, a second layer (10) serving as an anode layer of a second conductivity type and further layers (14, 16) acting as anode and cathode contacts. Furthermore, a junction termination region (24) arranged in a circumferential region surrounding the second layer (10) is provided and comprises self-contained sub-regions (26) of the second conductivity type embedded into the first layer (2). Additionally, a low doping region (50) is provided in an intermediate region between the second layer (10) and the junction termination region (24). The proposed combination of junction termination region (24) and low doping region (50) may result in improved electrical characteristics while maximizing a safe operating area of the device (1). Particularly when the anode layer (10) is provided with a double anode structure comprising a heavily doped shallow portion (50) and a lightly doped deep portion (40), the proposed semiconductor device may be produced advantageously using only a single masking step during ion implantation for generating the second layer (10), the junction termination region (24) and the low doping region (42) simultaneously.

## Description

### FIELD OF THE INVENTION

The present invention relates to the field of power electronics. More particularly, the present invention relates to a power semiconductor device such as a power diode, IGBT or reverse-conductive IGBT with improved electrical characteristics as well as a method for producing such device.

### TECHNICAL BACKGROUND

In power electronics devices such as power diodes as used e.g. in insulated gate bipolar transistors (IGBT) or integrated gate commutated thyristors (IGCT), critical electrical characteristics such as blocking capability or leakage current may strongly depend on a design of differently doped layers.

Recently, a fast recovery diode has been developed (see the European patent application 09175419.2, not published yet). As exemplarily shown in figure 1 in cross-section, such vertical power diode 101 typically comprises a first layer 102 forming a low n- doped base layer 104 having a first main side 106 and a second main side 108. On the first main side 106, a high p+ doped anode layer 110 is formed. On the second main side 108, a high n+ doped cathode layer 112 may be formed. The anode and cathode layers 110, 112 are typically formed by implantation and a subsequent diffusion of dopants into an n- doped substrate (wafer).

On their outer side the anode layer 110 and the cathode layer 112 are covered with metal layers in form of anode and cathode metallizations 114, 116 for electrically contacting the diode 101. The cathode layer 112 and metallization 116 normally extend to a physical edge 118 of the device 101. The anode layer 110, on the other hand, has to be terminated at some distance from the edge 118 of the device 101, thereby forming an edge 120 of the active area, in order to be able to support an electric field when reverse biased. Normally, this is done by limiting the p+ doped anode layer 110 to a central part 122 of the diode 101 and surrounding it by a ring-shaped field-limiting junction termination region 124, sometimes also referred to as "guard ring".

The junction termination region 124 comprises a plurality of ring-shaped p+ doped sub-regions 126 having a widths of e.g. between 5 µm and 50 µm and being alternately implemented into a ring-shaped n- region 128 being part of the base layer 104 such that each of the p+ type sub-regions 126 is electrically disconnected from neighbouring p+ type sub-regions 126 as well from the p+ type anode layer 110. A design, i.e. an arrangement and dimensions of the sub-regions 126, 128 may have to be specifically optimized for each type of power diode and may depend e.g. on voltage, power and switching requirements for a specific power device.

The anode metallization 114 has about the same size as the p+ doped anode layer 110. The area underneath the p+ doped anode layer 110 that is between the p+ doped anode layer 110 and the n+ doped cathode layer 112 is normally defined as the active area 130 of the diode 101. It is enclosed by a circumferential area 132.

A typical application for such a power diode 101 is a free-wheeling diode in an IGBT inverter circuit. In such an application, the critical part of the diode operation may appear when the diode 101 is switched-off from a conducting on-state to a blocking off-state as the IGBT is switched on.

Due to known effects which are e.g. described in the applicant's patent application EP 1 909 332 A1, high voltage diodes may require local lifetime control in the active area 130 for optimized electrical properties in blocking, switching and conduction state. Therefore, a lifetime control region 134 may be generated close to the anode side surface of the diode 101. This lifetime control region 134 comprises defects forming recombination centres which may locally reduce a minority carrier lifetime within adjacent semiconductor material. For example, such defects may be generated by irradiating the anode side surface with ions like hydrogen ions or helium ions. These defects may act as recombination centers and reduce the voltage peak during diode turn off often referred to as reverse recovery.

When the anode layer 110 is prepared with a single ion implantation step, steep doping profiles may require that a depth at which the lifetime control region 134 is generated has to be tightly controlled. In order to relax such control requirements, a diode design has been proposed in which both, the p+ type anode layer 110 and the p+ type sub-regions 126 of the junction termination region 124 are formed with a two-step implantation procedure. Therein, a first low concentration of dopants is implanted at the respective surface areas and is subsequently spread during a high temperature diffusion step in order to form a deep p doped regions 136, 140. Then, in a second step, a high concentration of dopants is implanted at the respective surface areas in order to form shallow p+ doped regions 138, 142 which are enclosed by the deep regions 136, 140. Thereby, a "double anode structure" comprising shallow heavy doped regions 138, 142 and deep light doped regions 136, 140 may be created. With such double anode structure, a control requirement concerning an implantation depth of the lifetime control region 134 may be relaxed.

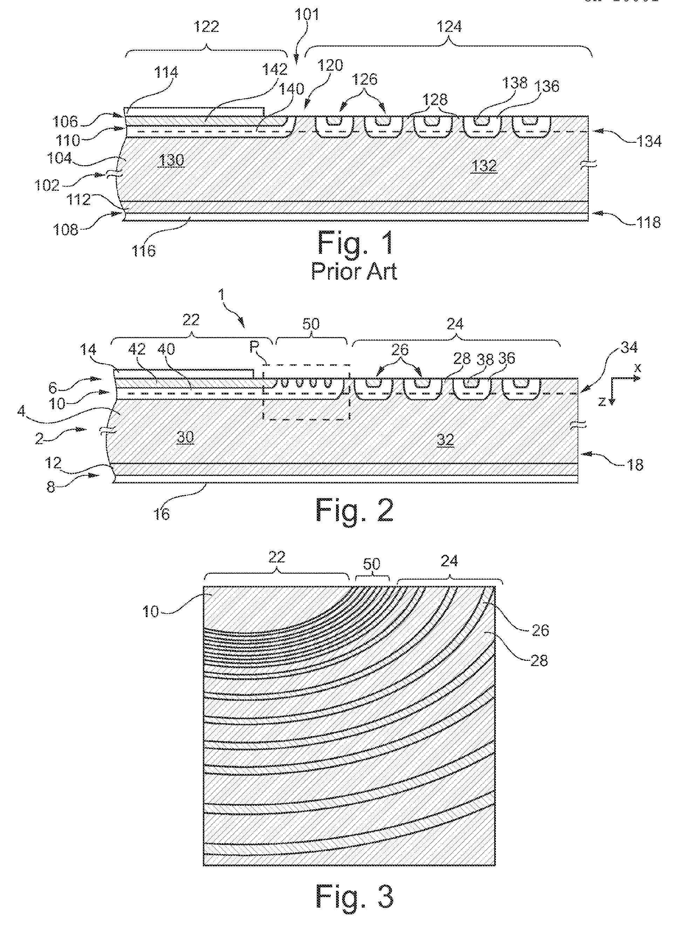

However, it has been observed that high power diodes having e.g. a design similar to that shown in figures 1 may suffer from non-optimum electrical characteristics such as e.g. non-optimum electrical blocking capability and/or switch off performance often referred to as safe operating area.

### DISCLOSURE OF THE INVENTION

It may be an object of the present invention to provide a power semiconductor device having improved electrical characteristics and a method for producing such device. Particularly, it may be an object of the present invention to provide a power semiconductor device such as a power diode having improved electrical blocking capability while at the same time providing satisfying switch-off characteristics.

These objects may be met by the semiconductor device and the producing method according to the appended independent claims. Embodiments of the invention are given in the dependent claims.

According to a first aspect of the present invention, a power semiconductor device is proposed, comprising: (a) a first layer of a first conductivity type, e.g. n type, which first layer has a first main side and a second main side opposite to the first main side; (b) a second layer of a second conductivity type, e.g. p type, which second layer is arranged in a central region on the first main side; (c) a third electrically conductive layer which is arranged on the second layer on a side opposite to the first layer; and (d) a fourth electrically conductive layer which is arranged on the second main side of the first layer. The power semiconductor device further comprises a junction termination region arranged in a circumferential region on the first main side, the junction termination region comprising at least one self-contained sub-region surrounding the second layer, the sub-region being of the second conductivity type and being embedded into the first layer. Furthermore, the power semiconductor device comprises a low doping region arranged in an intermediate region of the first main side between the second layer and the junction termination region, wherein the low doping region is of the second conductivity type and laterally merges with the second layer, and wherein the low doping region has an average doping concentration significantly lower than an average doping concentration of the second layer.

Important features and ideas of the proposed inventive power semiconductor device and the proposed method for producing such device may be based on the following recognitions and considerations:
Concerning the structure of the first to fourth layer, the proposed semiconductor device may be similar to prior art devices such as shown in Fig. 1. Therein, an anode layer formed by the second layer may be limited to a central region of the device's first main side such as to be spaced apart from an edge of the device. In order to improve electrical characteristics of the device, it is proposed herein to enclose the anode layer by a combination of a junction termination region (guard ring) and a low doping region. The low doping region may have a high resistivity being significantly higher than a resistivity within the second layer. For example, an average doping concentration within the low doping region may be smaller by factor 5, preferably smaller by a factor 10 or even 100, than a doping concentration within the second layer. Preferably, the low doping region merges with the second layer, i.e. is in direct contact and is therefore electrically connected to the second layer. Accordingly, charge carriers may flow from the second layer to the low doping region. It is believed that the proposed combination of a low doping region with high resistivity and adapted guard rings within a junction termination region may separate a maximum electric field from a maximum current within the semiconductor device and thereby may prevent early device destruction during device turn-off. Due to the high resistivity in the low doping region, the current may be suppressed and an effective doping decreased. The current may be suppressed resulting in a decreased effective doping of the p-layer during device turn-off, which is related to the amount of current flowing.

In the low doping region a doping density may remain constant. Alternatively, the doping density may decrease laterally in a direction from an inner region adjacent to the second layer towards an outer region adjacent to the junction termination region. A low doping region with such laterally varying doping concentration may also be referred to as VLD region (variation of lateral doping).

As will be described in more detail further below, synergy effects of the combination of low doping region and junction termination region may specifically be obtained for a case of a double anode structure. Specifically with such double anode structure, the anode layer, the junction termination region and the low doping region may be advantageously produced using a single masking step and two ion implantation steps with a diffusion step in between. Therein, a constant resistivity within the low doping region or a locally varying resistivity within the VLD region may be determined by suitably designing the mask as well as suitably adapting the implantation steps and the diffusion steps. In the produced power semiconductor device, electrical characteristics such as the electrical blocking capability and switch-off characteristics may be improved by the proposed combination of low doping region and junction termination region while at the same time advantageously reducing a loss of SOA (Safe Operating Area) compared to devices with double anode and conventional guardring design.

It has to be noted that aspects and embodiments of the present invention are described herein with reference to different subject-matters. In particular, some features are described with reference to the method for producing the semiconductor device whereas other features are described with reference to the semiconductor device itself. However, a person skilled in the art will gather from the above and the following description that, unless other notified, in addition to any combination or features belonging to one type of subject-matter also any combination between features relating to different subject-matters, in particular between features of semiconductor device and features of the method for producing such device, is considered to be disclosed with this application.

### BRIEF DESCRIPTION OF THE DRAWINGS

Embodiments of the invention will be explained in more detail in the following text with reference to the attached drawings in which:
Fig. 1 shows a cross-sectional view of a prior art power diode.
Fig. 2 shows a cross-sectional view of a power diode according to an embodiment of the present invention.
Fig. 3 shows a top view onto the power diode shown in Fig. 2.
Fig. 4 shows an enlarged cross-sectional view of a portion P indicated in Fig. 2.
Fig. 5 shows a graph indicating a locally varying doping concentration along a line A-A as indicated in Fig. 4.
Fig. 6 shows a graph indicating a locally varying doping concentration along a line B-B as indicated in Fig. 4.
Fig. 7 shows a graph indicating a locally varying doping concentration along a line C-C as indicated in Fig. 4.

The reference symbols used in the figures and their meaning are summarized in the list of reference symbols attached hereto. The drawings are only schematically and not to scale. Generally, alike or alike-functioning parts are given the same or corresponding reference symbols. The described embodiments are meant as examples only and shall not limit the invention.

### MODES FOR CARRYING OUT THE INVENTION

Fig. 2 and Fig.3 show an embodiment of a power semiconductor device in a form of a power diode in a cross-sectional view and a top view, respectively.

In a high quality float zone silicon wafer serving as a substrate, a first layer 2 is provided. This first layer 2 has, as a first conductivity type, an n type doping. The first layer 2 comprises a first main side 6 and a second main side 8 opposite to the first main side 6. Within the first layer 2, an (n-) type region forming a base layer 4 and an (n+) type region forming a cathode layer 12 are provided. In a central region 22 of the first main side 6, a second layer 10 forming an anode layer and having, as a second conductive type, a (p+) type doping is provided. Both, the (p+) type doping of the second layer 10 as well as the (n+) type doping of the cathode layer 12 may be generated by ion implantation of e.g. boron and phosphorous, respectively, and subsequent activation and diffusion of the implanted dopants at high temperatures.

On top of the second layer 10, a third electrically conductive layer 14 formed by a metallization may serve as an anode contact. A fourth electrically conductive layer 16 arranged on the second main side 8 of the first layer 2 or, more precisely, the cathode layer 12 included therein, is also formed by a metallization and may serve as a cathode contact.

In a circumferential region on the first main side 6 of the device 1, a junction termination region 24 is provided. Similarly as in prior art power semiconductor devices, this junction termination region 24 is arranged close to an edge 18 of the device 1 and surrounds and encloses the second layer 10 provided in the central region 22. The junction termination region 24 comprises a plurality of sub-regions 26 of the second conductivity type, i.e. (p+) type. The sub-regions 26 are embedded into the base layer 4 of the first conductivity type, i.e. n- type. A design of the junction termination region 24 may be optimized for a specific type of power semiconductor device. For example, such design may depend on voltage and current ratings, on an envisaged operating temperature, etc. Depending on such requirements, a width and depth of each of the sub-regions 26 and their doping profiles as well as spacings between neighboring sub-regions 26 may be optimized. Each of the width, depth and spacing as well as respective doping profils may vary from one sub-region 26 to another sub-region 26. As such design optimization may be time-consuming and laborious, a same junction termination region design may be used for a power semiconductor device according to embodiments of the present invention as for prior art power semiconductor devices. Accordingly, an already existing optimized design does not necessarily have to be re-calculated for a device according to an embodiment of this invention.

Between the central region 22 comprising the anode layer 10 and the junction termination region 24, a low doping region 50 is arranged on the first main side 6. In the specific embodiment shown in figs. 2 and 3, the low doping region is provided as a VLD region 50 in which an average doping density decreases in a lateral direction (x-direction in fig.2) towards the edge 18. However, in alternative embodiments, the variation of lateral doping may not be present. Instead, the doping concentration may be constant in a lateral direction or may vary e.g. in a periodically alternating manner. The low doping region 50, e.g. a VLD region, is of the second conductivity type, i.e. p type and/or p+ type. A doping concentration within the VLD low doping region may vary such that a doping density decreases laterally in a direction from an inner region adjacent to the anode layer 10 towards an outer region adjacent to the junction termination region 24. In other words, an electrical resistivity within the VLD low doping region 50 increases laterally in a direction towards the edge 18 of the device 1.

In the specific embodiment shown in Fig. 2, the anode layer 10 as well as the junction termination region 24 and the VLD low doping region 50 may comprise a double layer structure such that heavily (p+) doped portions are embedded in lightly p doped regions. In other words, for example the second layer 10 (anode layer) is formed with a double anode structure comprising a shallow portion 42 having a doping concentration e.g. in the order of 1e18 cm⁻³ embedded into a deep portion 40 having for example a doping concentration in the order of between 5e14 cm⁻³ to 5e15 cm⁻³. The shallow portion 42 exemplarily has a maximum doping concentration, which is a factor of 100, exemplarily a factor of 200, exemplarily a factor of 500 higher than the maximum doping concentration of the deep portion 40. The shallow portion 42 is arranged directly at the surface at the main first side 6 and has a thickness of between 1 µm and 10 µm whereas the deep portion 40 is arranged underneath and has a thickness of between of 4 µm to 30 µm. The shallow portion 42 is exemplarily embedded into the deep portion 40.

A similar double structure is also comprised in the sub-regions 26 of the junction termination region 24. Each sub-region 26 comprises a heavily p+ doped shallow portion 38 and a lightly p doped deep portion 36. Therein, each of the self-contained sub-regions 26 including their deep portions 36 is spaced apart from a neighboring sub-region 26 by an intermediate (n-) type sub-region 28 such that the p type sub-regions 26 are electrically separated from each other. Self-contained regions are regions which are closed. These regions may be formed as rings, squares or any other appropriate design.

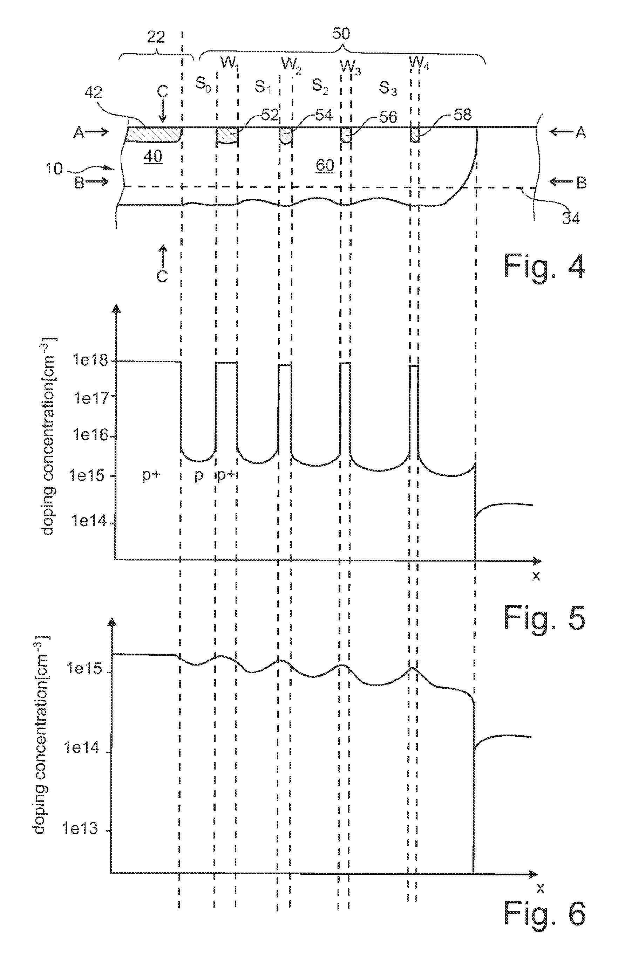

Also the VLD region 50 comprises a double layer structure. As shown in the enlarged view of Fig. 4 representing the region P indicated in Fig. 2, the VLD low doping region 50 comprises a plurality of heavily p+ doped shallow portions 52, 54, 56, 58 which are embedded into a common lightly p doped deep portion 60. Each of the shallow portions 52, 54, 56, 58 as well as the deep portion 60 is self-contained and encloses the inner region 22 with the anode layer 6 comprised therein. While the shallow portions 52, 54, 56, 58 are spaced apart with respect to each other and with respect to the shallow portion 42 of the anode layer 10, the deep portion 60 of the VLD region 50 overlaps and merges with the deep portion 40 of the anode layer 10. Accordingly, there is an electrical contact between the anode layer 10 and the VLD layer region 50 via their respective deep portions 40, 60. Therein, due to a specific production process as will be further described below, an electrical resistivity within the deep portion 60 of the VLD low doping region 50 increases from an inner region, where the deep portion 60 of the VLD low doping region 50 merges with the deep portion 40 of the anode layer 10, towards an outer region in a direction towards the adjacent junction termination region 24. Also due to the specific production process used for generating the VLD region 50, widths w₁, w₂, w₃, w₄ of the shallow portions 52, 54, 56, 58 may decrease from the inner region towards the outer region. Alternatively or additionally thereto, spacings s₁, s₂, s₃ between the shallow portions 52, 54, 56, 58 may increase from the inner region towards the outer region.

In order to improve switching characteristics of the diode, a lifetime control region 34 comprising defects forming recombination centres which may locally reduce a minority carrier lifetime within adjacent semiconductor material is provided. This lifetime control region 34 is formed at a depth from the surface from the first main side 6 such that it extends in the deep portions 40, 60, 36 of the anode layer 10, the VLD region 50 and the junction termination region 24. Furthermore, the lifetime control region 34 may but not necessarily has to reach partially into their shallow portions 42, 52, 54, 56, 58, 38.

In conventional devices as e.g. shown in fig. 1, it has been observed that under static or quasi static blocking conditions when the device is reversed biased the lower doped deep portions 136, 140, in particular the distances between them, may mainly determine the blocking characteristics due to a low amount of current flowing. During device turn-off the higher doped shallow portions 42 and the lower doped deep portions 36 are responsible for the safe-operating area SOA due to an effective doping by the higher current flowing. Since the distances between the (p)-type deep portions 140 to 136 and the shallow portion 142 to the 1^{st} guardring's shallow portion 136 are not equal the device may fail in the one or the other mode of operation. The device design proposed herein is promising to overcome such deficiencies.

The inventive design of the low doping region 50 and junction termination region 24 can be applied for a diversity of power semiconductor devices such as a power diode, an insulated gate bipolar transistor (IGBT), an integrated gate commutated thyristor (IGCT), an PCT or reverse-conductive IGBT. Reverse conductive IGBTs may be formed as bipolar insulated gate transistor (BIGT; e.g. disclosed in the applicant's European patent application 09159009.1, not published yet).

A method according to an embodiment of the present invention for producing a power semiconductor device 1 as for example shown in Fig. 2, 3 and 4 is described as follows:
A semiconductor substrate such as a silicon wafer is provided. The substrate comprises, as a first conductivity type, a light (n-) doping forming the base layer 4.

On the second main side 8, an (n+) type cathode layer 12 may be formed by ion implantation of e.g. phosphorous ions. This cathode layer 12 may cover the entire second main side 8.

In order to form the anode layer 10, the junction termination region 24 and the low doping region region 50, boron ions may be implanted into the first main side 6. For this purpose, a structured oxide mask may be applied to the first main side 6 by first depositing an oxide layer onto the first main side 6 and then locally removing this oxide layer using a resist mask and a subsequent etching step. This oxide mask may cover all areas of the first main side 6 where no ions shall be implanted. For example, referring to Fig. 4, the spacings s₀, s₁, s₂, s₃ may be covered by the oxide mask.

In a first ion implantation step, boron ions are implanted at the areas of the first main side 6 not protected by the oxide mask with a low dose of e.g. between 1e12 cm⁻² and 5e13 cm⁻².

Subsequently, the implanted ions may be activated and distributed in a high temperature diffusion step in which the entire substrate is held at e.g. 1.200°C during 24 hours. This time is exemplarily longer than the diffusion time for a subsequent diffusion of the second implanted ions. During such diffusion step, the dopants which have originally been introduced in the uncovered areas with a shallow depth, may diffuse both, in a depth direction (z-direction in Fig. 2) and in a lateral direction (x-direction in Fig. 2) such that one of the deep regions 40, 60, 36 of the anode layer 10, the low doping region 50 and the junction termination region 24, respectively, may be formed. Depending on the temperature and the duration of the diffusion step, a depth of the deep regions of about 4 - 30 µm may be obtained. Similarly, lateral dimensions of the deep regions 40, 60, 36 originating from the previously implanted smaller areas may be enlarged during the diffusion step. Furthermore, during the drive-in diffusion process, an additional oxide is grown on the entire first main side 6. As a result, the first main side 6 ends up being covered by a structured oxide having thick oxide portions where the initial oxide mask existed and thin oxide portions at the previous openings in the oxide mask.

Then, in a second ion implantation procedure, boron ions are implanted into the first main side 6 in the areas masked by the structured thin oxide portions. This time, a higher implantation dose of for example more than 1e15 cm⁻² to 8e15 cm⁻² may be used. An energy of the implantation ions is selected such that the ions may transit the thin oxide portions but are blocked by the thick oxide portions. Thereby, the shallow portions 42, 52, 54, 56, 58, 38 of the second layer 10 (anode layer), the VLD region 50 and the junction termination region 24, respectively, may be formed. As the dopants implanted in this second step are not or only slightly diffused in subsequent high temperature steps, the heavily doped shallow portions are embedded into the previously generated lightly doped deep portions 40, 60, 36. Accordingly, a double layer structure may be generated for the second layer 10 as well as for the VLD low doping region 50 and the junction termination region 24. No further application of a shadow mask or a resist mask may be necessary for the second ion implantation step. Accordingly, the entire double layer structure may be completed with a single masking step.

In order to generate a VLD region 50 with a increasing electrical resistivity, i.e. with a decreasing doping concentration, in a direction laterally from the inside to the outside of the device 1, specific design rules for the ion implantation procedure, i.e. design rules for the mask used therein, may apply. The spacings s₁, s₂, s₃ between the uncovered areas of the VLD low doping region 50 should be small enough such that the subsequent diffusion step may lead to an overlap of the low doped deep regions in order to form the common deep region 60 of the VLD region 50. Therein, the spacings s₁, s₂, s₃ may increase from an inside region to the outside region (s₁ ≤ s₂ ≤ s₃) such that the overlap becomes less towards the outside region thereby increasing a resistivity of the deep region 60 towards the outside region. For the same purpose, a width w₁, w₂, w₃, w₄ of adjacent uncovered areas may decrease from the inside to the outside region (w₁ ≥ w₂ ≥ w₃ ≥ w₄). Furthermore, in order to prevent that the shallow portions 52, 54, 56, 58 generated in the second ion implantation step overlap after subsequent diffusion drives thereby potentially forming a low-resistivity path close to the device surface at the first main side 6, the spacings s₀, s₁, s₂, s₃ have to be selected large enough. Typically, such spacings sᵢ are in a range of 2 µm - 25 µm wherein the widths wᵢ are in a range of 0.5 µm - 10 µm. Thereby, non-overlapping shallow regions 52, 54, 56, 58 with a doping concentration of about 1e18 cm⁻³ and a common, overlapping deep region 60 with a doping concentration decreasing from an inner side value of e.g. 5e14 cm⁻³ to 1e16 cm⁻³ to an outer side value of e.g. 1e14 cm⁻³ to 1e16 cm⁻³ may be generated.

In Figs. 5 and 6, a lateral distribution of the doping concentration (x-direction in Fig. 2) is shown along different lines A-A and B-B, wherein A-A is close to a surface on the first main side 6 and intersects the shallow portions 42, 52, 54, 56, 58 whereas B-B is deeper inside the substrate and extends through the deep portions 40, 60. As may be derived from Fig. 5, while the peak doping concentrations within the shallow portions 42, 52, 54, 56, 58 remains constant, the doping concentration in intermediate regions corresponding to the spacings s₀, s₁, s₂, s₃ decreases towards an outside region of the VLD region 50. This may also be observed in Fig. 6, where a doping concentration may locally vary depending on a respective distance to an ion implanted area prior to diffusion distribution, but an averaged doping concentration decreases laterally coming from the deep portion 40 of the anode layer 10 and further extending through the common deep portion 60 towards an outside region. Thus, the electrical resistivity increases within the low doping region 50 such as a VLD region from the inside to the outside region.

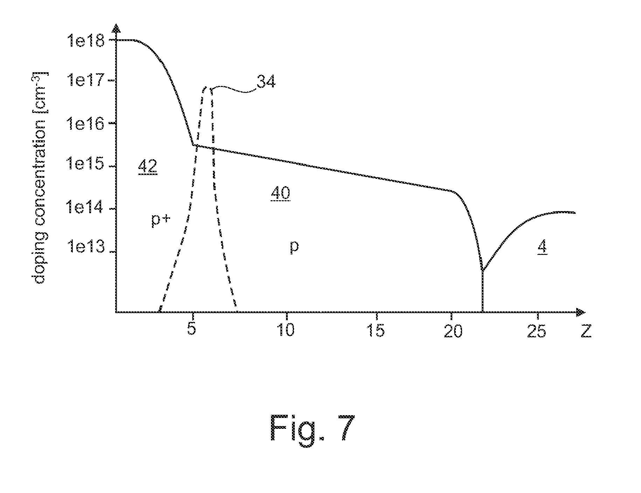

Fig. 7 shows a profile of a doping concentration along a depth-direction (z-direction in Fig. 2) along a line C-C as shown in Fig. 4. A p+ type shallow portion 42 of the anode layer 10 has a depth of approximately 5 µm. A p type deep region 40 extends to a depth of more than 20 µm and is then followed by the (n-) type base layer 4.

A lifetime control region 34 comprising defects forming recombination centres is then generated by irradiating the first main side 6 with ions like hydrogen ions or helium ions. Therein, an energy of the ions is selected such that the ions are preferably implanted at a depth being deeper than the depth of the shallow portions 42, 52, 54, 56, 58, 38 but less deep than the deep portion 40, 60, 36.

Finally, electrical contacts are formed by providing electrically conductive third and fourth layers 14, 16 onto the anode layer 10 and the cathode layer 12, respectively.

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.
Alternatively to the description above, the conductivity types of the layers can also be switched, i.e. all layers of the first conductivity type are p type (e.g. the base layer 4) and all layers of the second conductivity type are n type (e.g. the second layer 10).

### LIST OF REFERENCE SIGNS

- 1: Semiconductor device
- 2: First layer
- 4: Base layer
- 6: First main side
- 8: Second main side
- 10: Second layer
- 12: Cathode layer
- 14: Third electrically conductive layer
- 16: Fourth electrically conductive layer
- 18: Edge
- 22: Central region
- 24: Junction terminal region
- 26: Sub-region of second conductivity type
- 28: Sub-region of first conductivity type
- 30: Active area
- 32: Circumferential area
- 34: Lifetime control region
- 36: Deep portion
- 38: Shallow portion
- 40: Deep portion
- 42: Shallow portion
- 50: Low doping region
- 52: Shallow portion
- 54: Shallow portion
- 56: Shallow portion
- 58: Shallow portion
- 60: Common deep portion

- 101: Semiconductor device
- 102: First layer
- 104: Base layer
- 106: First main side
- 108: Second main side
- 110: Anode layer
- 112: Cathode layer
- 114: Anode metallization
- 116: Cathode metallization
- 118: Edge
- 120: Edge of active area
- 122: Central region
- 124: Junction terminal region
- 126: Sub-region of second conductivity type
- 128: Sub-region of first conductivity type
- 130: Active area
- 132: Circumferential area
- 134: Lifetime control region
- 136: Deep portion
- 138: Shallow portion
- 140: Deep portion
- 142: Shallow portion

## Claims

1. Power semiconductor device (1) comprising
- a first layer (2) of a first conductivity type, which has a first main side (6) and a second main side (8) opposite the first main side (6),
- a second layer (10) of a second conductivity type, which is arranged in a central region (22) of the first main side (6),
- a third electrically conductive layer (14), which is arranged on the second layer (10) on a side opposite to the first layer (2),
- a fourth electrically conductive layer (16), which is arranged on the second main side (8) of the first layer (2),
**characterized in that** the power semiconductor device (1) further comprises
- a junction termination region (24) arranged in a circumferential region of the first main side (6), the junction termination region (24) comprising at least one self-contained sub-region (26) surrounding the second layer (10), the sub-region (26) being of the second conductivity type and being embedded into the first layer (2), and
- a low doping region (50) arranged in an intermediate region of the first main side (6) between the second layer (10) and the junction termination region (24), wherein the low doping region (50) is of the second conductivity type and wherein the low doping region (50) has an average doping concentration lower than an average doping concentration of the second layer (10).

2. The power semiconductor device (1) of claim 1, wherein
in the low doping region (50) a doping density remains constant or decreases laterally in a direction from an inner region adjacent to the second layer (10) towards an outer region adjacent to the junction termination region (24).

3. The power semiconductor device (1) of claim 1 or 2, wherein all, the second layer (10), the sub-regions (26) of the junction termination region (24) and the low doping region (50) comprise shallow portions (42, 38, 52, 54, 56, 58) closer to the first main side (6) and deep portions (40, 36, 60) extending from the shallow portions (42, 38, 52, 54, 56, 58) deeper into the first layer (2), wherein the shallow portions (42, 38, 52, 54, 56, 58) have a higher doping concentration than the deep portions (40, 36, 60).

4. The power semiconductor device (1) of claim 3, wherein the low doping region (50) comprises an inner region adjacent to the second layer (10), an outer region adjacent to the junction termination region (24) and a plurality of shallow portions (52, 54, 56, 58) and wherein at least one of the following conditions applies: (a) a width wᵢ of the shallow portions (52, 54, 56, 58) decreases from the inner region to the outer region; (b) a spacing sᵢ between adjacent shallow portions (52, 54, 56, 58) increases from the inner region to the outer region; and (c) both width wᵢ and spacing sᵢ remain constant.

5. The power semiconductor device (1) of one of claims 1 to 4, wherein the low doping region (50) is merged with the second layer (10).

6. The power semiconductor device (1) of one of claims 1 to 4, wherein the low doping region (50) is spaced apart from an inner most sub-region (26) of the junction termination region (24).

7. Method for producing a power semiconductor device (1), the method comprising:
- providing a semiconductor substrate forming a first layer (2) having a first conductivity type and having a first main side (6) and a second main side (8) opposite the first main side (6),
- forming a second layer (10) of a second conductivity type, which second layer (10) is arranged in a central region (22) on the first main side (6),
- forming a third electrically conductive layer (14) which is arranged on the second layer (10) on a side opposite the first layer (2),
- forming a fourth electrically conductive layer (16) which is arranged on the second main side (8) of the first layer (2),
**characterized in that** the method further comprises
- forming a junction termination region (24) arranged in a circumferential region on the first main side (6), the junction termination region (24) comprising at least one self-contained sub-region (26) surrounding the second layer (10), the sub-region (26) being of the second conductivity type and being embedded into the first layer (2), and
- forming a low doping region (50) arranged in an intermediate region of the first main side (6) between the second layer (10) and the junction termination region (24), wherein the low doping region (50) is of the second conductivity type and wherein the low doping region (50) has an average doping concentration lower than an average doping concentration of the second layer (10).

8. The method of claim 7, wherein the low doping region (50) is formed with a doping density decreasing laterally in a direction from an inner region adjacent to the second layer (10) towards an outer region adjacent to the junction termination region (24).

9. The method of claim 8, wherein the low doping region (50) is formed by ion implantation of dopants into partial regions (52, 54, 56, 58) of the low doping region (50) and subsequent distribution of the dopants in a diffusion process, wherein the partial regions (52, 54, 56, 58) are spaced apart and doped with a doping concentration such that during the diffusion process adjacent partial regions (52, 54, 56, 58) merge.

10. The method of one of claims 7 to 9, wherein all, the second layer (10), the sub-regions (26) of the junction termination region (24) and the low doping region (50) are formed with shallow portions (42, 38, 52, 54, 56, 58) closer to the first main side (6) and with deep portions (40, 36, 60) extending from the shallow portions (42, 38, 52, 54, 56, 58) deeper into the first layer (2), wherein the shallow portions (42, 38, 52, 54, 56, 58) are formed with a higher doping concentration than the deep portions (40, 36, 60).

11. The method of claim 10, wherein the deep portions (40, 36, 60) are formed with a first ion implantation process using a mask for defining implantation regions and a subsequent ion diffusion process and wherein the shallow portions (42, 38, 52, 54, 56, 58) are formed with a second ion implantation process using a mask for defining implantation regions.

12. The method of claim 11 wherein the first and the second implantation process are performed using a single mask.

13. The method of claim 11 or 12, wherein dimensions of implantation regions, implantation doses and a diffusion duration are selected such that, in the finalized low doping region (50), the deep portions (60) laterally overlap and the shallow portions (52, 54, 56, 58) do not laterally overlap.

14. The method of claim one of claims 10 to 13, wherein the low doping region (50), which comprises an inner region adjacent to the second layer (10) and an outer region adjacent to the junction termination region (24), is formed with a plurality of shallow portions (52, 54, 56, 58) and wherein at least one of the following conditions applies: (a) a width wᵢ of the shallow portions (52, 54, 56, 58) decreases from the inner region to the outer region; (b) a spacing sᵢ between adjacent shallow portions (52, 54, 56, 58) increases from the inner region to the outer region; and (c) both width wᵢ and spacing sᵢ remain constant.

15. The method of one of claims 9 to 14, wherein the low doping region (50) is formed such as to merge with the second layer (10).
